# EUROPÄISCHE PATENTANMELDUNG

(11) **EP 1 083 635 A2**
(43) Veröffentlichungstag der Anmeldung: **14.03.2001**
(21) Anmeldenummer: 00113542.5
(22) Anmeldetag: 27.06.2000
(51) Int. Cl.: H01R 13/533, H01R 9/24, H01R 13/66, H01R 25/00

(54) **Verteiler zum Verbinden von Aktoren und/oder Sensoren**

(30) Priorität: 09.09.1999 DE 29915886 U
(71) Anmelder: Weidmüller Interface GmbH & Co., 32760 Detmold (DE)
(72) Erfinder: Reker, Stefan, 33659 Bielefeld (DE)
(74) Vertreter: Dantz, Jan Henning

(57) **Zusammenfassung**

Ein Verteiler zum Verbinden von Aktoren und/oder Sensoren mit einem elektrischen Gerät, wie einer Steuerung, umfaßt ein Bauteil (1), an dem mehrere Anschlüse (2) für die Versorgung der Aktoren und/oder Sensoren und die Weiterleitung der Aktoren-Sensoren-Signale und eine Elektronikeinheit, die benachbart zu den Anschlüssen (2) an dem Bauteil (1) angeordnet ist. Erfndungsgemäß ist die Elektronikeinheit von einem auf dem Bauteil (1) angeordneten Gehäuse (3, 13) aus Metall umgeben. Vorzugsweise ist das Gehäuse (3, 13) abgedichtet an dem Bauteil (1) angebracht. Durch die Ausbildung des Verteilers ist es möglich, diesen auch in Bereichen einzusetzen, die wegen Wasser-, Hitze- oder Druckeinwirkungen und aus Gründen der elektromotorischen Verträglichkeit einen besonderen Schutz des Verteilers erfordern.

## Beschreibung

Die Erfindung betrifft einen Verteiler zum Verbinden von Aktoren und/oder Sensoren nach dem Oberbegriff des Anspruches 1. Solche Verteiler dienen insbesondere zum Anschluß von Aktoren bzw. Sensoren mit einem externen elektrischen Gerät, wie einer Steuerungseinheit in Form eines PC oder einer SPS und zur Weiterleitung von Aktoren-Sensoren-Signalen z.B. an ein Bussystem.

In der auf die Anmelderin zurückgehende DE 299 05 025 U1, die keinen vorveröffentlichten Stand der Technik bildet, ist ein Verteiler gezeigt, der mehrere Anschlüsse für die Aktoren und/oder Sensoren sowie eine Elektronik für die Versorgung der Aktoren und/oder Sensoren und die Weiterleitung der Aktoren-Sensoren-Signale aufweist. Bei diesem Verteiler ist die Elektronik auf einer Leiterplatte befestigt, wobei sowohl die Elektronik als auch die Leiterplatte jeweils in einem Gehäuse aus Kunststoff aufgenommen sind. Diese Ausbildung ist zwar kostengünstig herstellbar und einfach zu montieren, besitzt jedoch den Nachteil, daß der Verteiler für spezielle Anwendungsfalle, wie den Schiffbau, der Chemie, in rauhen Industrieanwendungen und Bereiche, in denen mit Explosivstoffen gearbeitet wird, aus Sicherheitsgründen nicht eingesetzt werden kann.

Es ist daher Aufgabe der vorliegenden Erfindung einen Verteiler zu schaffen, der auch in Bereichen eingesetzt werden kann, die wegen Wasser-, Hitze- oder Druckeinwirkungen und aus Gründen der elektromotorischen Verträglichkeit (EMV) einen besonderen Schutz des Verteilers erfordern.

Diese Aufgabe wird mit einem Verteiler mit den Merkmalen des Anspruches 1 gelöst. Wenn die an dem Bauteil angeordnete Elektronikeinheit von einem auf dem Bauteil angeordneten Gehäuse aus Metall umgeben ist, befindet sich die empfindliche Elektronikeinheit relativ sicher vor Umgebungseinflüssen geschützt in dem Gehäuse. Einerseits wird durch das Gehäuse aus Metall die Temperaturbeständigkeit des Verteilers verbessert, da Metall nicht so leicht schmilzt und nicht brennbar ist. Andererseits wird auch der Schutz vor mechanischen Einflüssen aufgrund der hohen Schlagfestigkeit des Gehäuses verbessert. Somit läßt sich der Verteiler auch in Bereichen einsetzen, in denen mechanische oder thermische Belastungen einen Einsatz ansonsten verhindert hätten.

Gemäß einer vorteilhaften Ausführungsform der Erfindung ist das Gehäuse abgedichtet an dem Bauteil angebracht. Dies ermöglicht eine Verwendung des Verteilers auch in einer Umgebung, in der Nässe und Feuchtigkeit die Elektronikeinheit beschädigen könnten. Vorzugsweise ist dabei an dem Gehäuse ein Kabelanschluß vorgesehen, an dem ein Kabel im wesentlichen abgedichtet in den Innenraum des Gehäuses geführt ist. Dies verringert die Kabelstrecke zu der Elektronikeinheit auf ein Minimum, wobei der Kabelanschluß an dem Gehäuse aus Metall besonders stabil befestigt werden kann.

Wenn das Gehäuse aus Metall mehrteilig ausgebildet ist, und an jedem Gehäuseteil ein Kabelanschluß vorgesehen ist, läßt sich das Gehäuse modulartig aus verschiedenen Komponenten zusammensetzen und für den jeweiligen Einsatzzweck anpassen.

Die Richtung des Kabelanschlusses relativ zu dem Bauteil läßt sich auf einfache Weise anpassen, wenn das Gehäuse mit dem Bauteil verschraubt ist und die Schrauben an dem Gehäuse in Draufsicht auf das Bauteil mit dem Gehäuse drehsymmetrisch um eine Gehäusemittelachse angeordnet sind. Vorzugsweise sind dabei an dem Gehäuse und dem Bauteil vier fluchtende Bohrungen vorgesehen, die in Draufsicht ein Quadrat ausbilden. Dadurch kann das Gehäuse jeweils um 90° gedreht werden, um den Kabelanschluß in der gewünschten Richtung zu arretieren.

In einer bevorzugten Ausgestaltung der Erfindung sind an dem Bauteil Bohrungen vorgesehen, mittels der ein erstes Gehäuseteil befestigt ist, und das erste Gehäuseteil weist weitere Bohrungen auf, an denen ein oder mehrere Gehäuseteile befestigbar sind. Diese Ausgestaltung ermöglicht eine individuelle Gestaltung der Gehäuses sowohl was die Bauhöhe der Gehäuses angeht, das z.B. zur Aufnahme einer gewissen Kabellänge auch höher ausgebildet sein kann, und Anzahl und Richtung der Kabelanschlüsse. Es können hierbei mehrere in eine oder mehrere Richtungen verlaufende Kabelanschlüsse vorgesehen sein, wobei der Raum des Gehäuses besonders gut genutzt wird, wenn ein Kabelanschluß seitlich an dem Gehäuse und ein Kabelanschluß an der Oberseite des Gehäuses vorgesehen sind.

Um die Funktionalität des Verteiler zu verbessern, ist vorzugsweise an dem Gehäuse ein Erdungsanschluß vorgesehen.

Um den Verteiler gegenüber der Umgebung noch unanfalliger für Umwelteinflüsse zu machen, sind vorzugsweise alle Bauteile des Verteilers aus Metall ausgebildet.

Die Erfindung wird nachfolgend anhand von zwei Ausführungsbeispielen mit Bezug auf die beigefügten Zeichnungen näher erläutert. Es zeigen:
- Fig. 1: eine perspektivische Ansicht eines ersten Ausführungsbeispieles eines erfindungsgemäßen Verteilers;
- Fig. 2: eine Seitenansicht des Verteilers der Fig. 1;
- Fig. 3: eine Draufsicht auf den Verteilers der Fig. 1;
- Fig. 4: eine Vorderansicht des Verteilers der Fig. 1;
- Fig. 5: eine perspektivische Ansicht eines zweiten Ausfürungsbeispieles eines erfindungsgemäßen Verteilers;
- Fig. 6: eine Seitenansicht des Verteilers der Fig. 5;
- Fig. 7: eine Draufsicht auf den Verteilers der Fig. 5, und
- Fig. 8: eine Vorderansicht des Verteilers der Fig. 5.

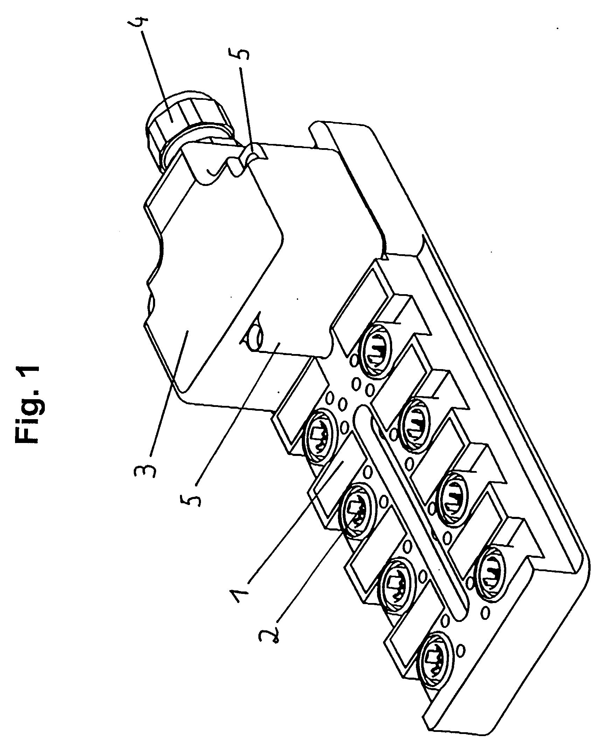

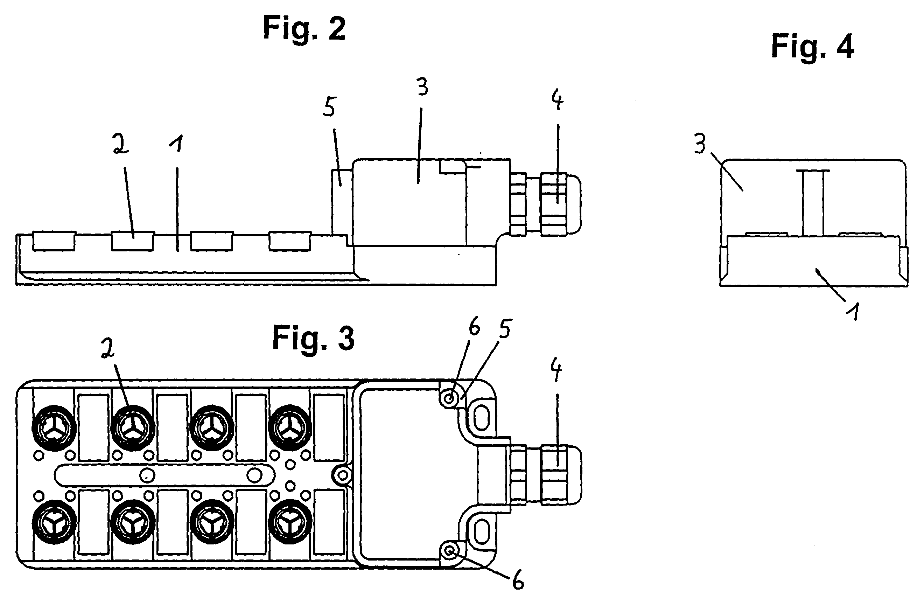

Der in den Fig. 1 bis 4 gezeigte Verteiler weist ein aus Metall bestehendes Bauteil 1 auf, an dem mehrere Anschlüsse 2 vorgesehen sind. Das Bauteil 1 besitzt eine Aktor-Sensor-Installation und eine passive Verkabelung. Die Anschlüsse 2 sind als Buchsen ausgebildet, in die die Stecker der zu den Aktoren und/oder Sensoren führenden Kabel eingesteckt werden können. In dem Bauteil 1 stehen die Anschlüsse 2 in elektrisch leitender Verbindung mit einer nicht dargestellten Leiterplatte, deren Leiterbahnen zu einer Gruppe von Kontaktstiften fuhren, die mit einer nicht näher dargestellten Elektronikeinheit verbunden sind. Ferner kann die Leiterplatte an dem Bauteil 1 mit einigen Leuchtdioden und Widerständen bestückt sein. Vorzugsweise werden für die Bauteile des Verteilers nur Materialien aus Metall und/oder Materialien verwendet, die besonders unempfindlich gegenüber Hitze und Stößen sind.

Die Elektronikeinheit ist unter einem Gehäuse 3 aus Metall angeordnet und fest mit der Leiterplatte verbunden. Das Gehäuse ist vorzugsweise durch ein Zink-Druckgußverfahren oder aus Aluminium hergestellt. Auch andere geeignete Metalle sind möglich. Die Verbindung und er Aufbau der Elektronikeinheit und der Leiterplatte kann so ausgebildet sein, wie es in der DE 299 05 025 U1 gezeigt ist.

Das Gehäuse 3 aus Metall weist einen Kabelanschluß 4 auf, der durch zwei Schraubbuchsen aus Metall gebildet ist, die ein Kabel abgedichtet in den Innenraum des Gehäuses 3 führen können. Das Gehäuse 3 ist mit Aufweitungen 5 versehen, in denen Bohrungen vorhanden sind. In den Bohrungen sind Schrauben 6 eingedreht, die das Gehäuse 3 fest mit dem Bauteil 1 verbinden.

Wenn der Verteiler an den Anschlüssen 2 und an dem Kabelanschluß 4 mit entsprechenden Kabeln und Leitungen angeschlossen ist, wird die empfindliche Elektronikeinheit durch das Gehäuse 3 und das Bauteil 1 aus Metall sicher vor Umwelteinflüssen abgeschirmt, wobei für besonders hohe Temperaturen jeweils eine Isolierung in dem Gehäuse 3 und an dem Bauteil 1 vorgesehen ist, die einer Übermäßige Erwärmung der Elektronikeinheit verhindert. Ferner ist in dem Gehäuse 3 eine Erdung vorgesehen.

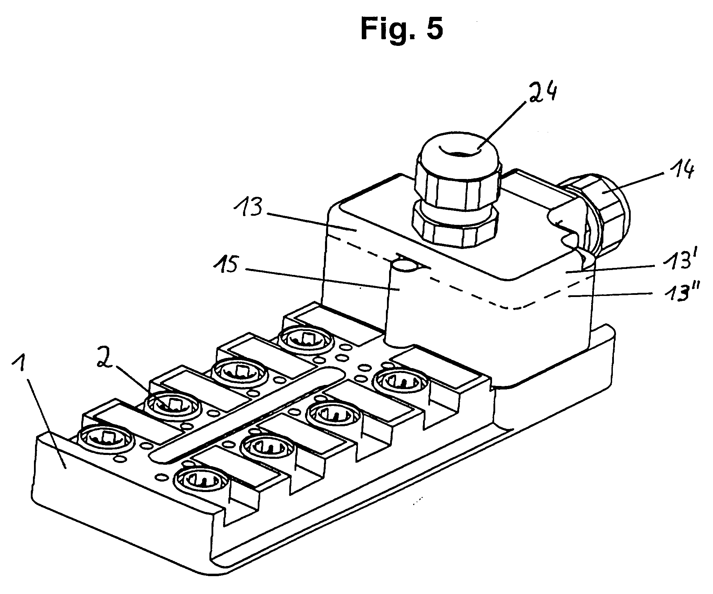

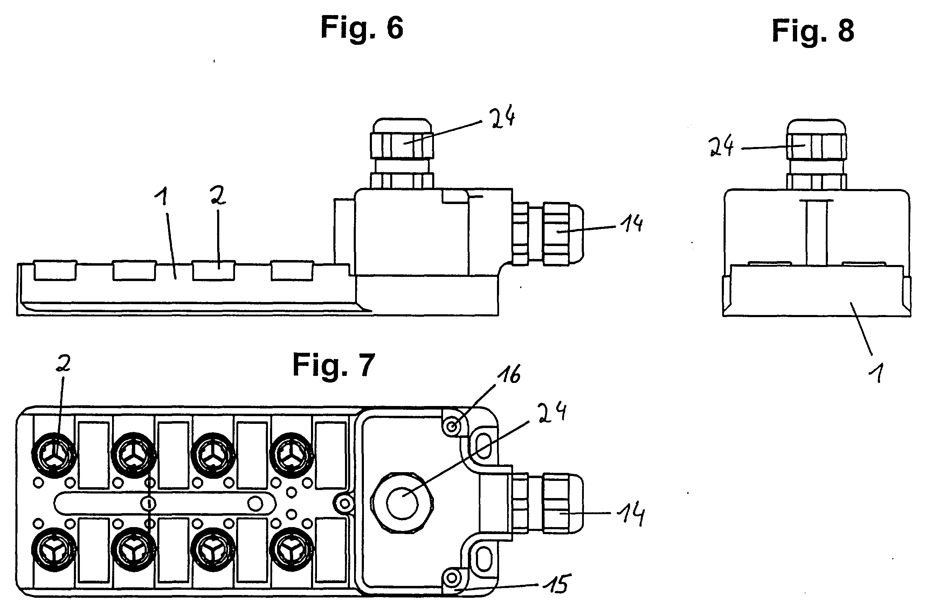

In dem in den Fig. 5 bis 8 dargestellten Ausführungsbeispiel ist das Bauteil 1 mit einem modifizierten Gehäuse 13 versehen. Aufbau und Innenleben des Bauteiles 1 können ansonsten dem in Fig. 1 gezeigten Bauteil entsprechen. Das Gehäuse 13 ist mit einem seitlichen Kabelanschluß 14 und einem oberen Kabelanschluß 24 aus Metall versehen, mittels denen jeweils ein Kabel abgedichtet in das Gehäuse 13 zu der Elektronikeinheit geführt werden kann. Das Gehäuse 13 ist mittels drei Schrauben 16, die durch in Aufweitungen 15 vorgesehene Bohrungen greifen, an dem Bauteil 1 befestigt.

Statt einem einteiligen Gehäuse kann ein mehrteiliges Gehäuse verwendet werden, wie dies in Fig. 13 mit gestrichelten Linien angedeutet ist. Ein unteres Gehäuseteil 13'' ist als Hohlprofil ausgebildet, an dem der seitliche Kabelanschluß 14 montiert ist. Das obere Gehäuseteil 13' ist als Haube ausgebildet und mit dem oberen Kabelanschluß 24 ausgerüstet. Es ist möglich, mehrere untere Gehäuseteile 13'' stapelweise übereinander anzuordnen, um mehrere seitlich herausgeführte Kabelanschlüsse vorzusehen oder die Bauhöhe des Gehäuses zu vergrößern.

Bei einer mehrteiligen Ausbildung des Gehäuses ist es möglich, ein Unterteil vorzusehen, das mit dem Bauteil 1 fest verbunden ist. Auf dieses Unterteil können dann mehrere Zwischenteile mit oder ohne Kabelanschluß montiert werden. Diese Zwischenteile können dann mit einem Deckel aus Metall gegenüber der Umgebung verschlossen werden. An den Verbindungsstellen einzelner Gehäuseelemente können ferner Dichtelemente vorgesehen sein.

Alternativ zu den drei Schrauben 16 können auch zwei oder vier Schrauben zur Befestigung des Gehäuses an dem Bauteil vorgesehen sein, die in Draufsicht um eine zentrale Achse, wie den oberen Kabelanschluß 24, symmetrisch angeordnet sein können. Dies ermöglicht die individuelle Ausrichtung eines seitlichen Anschlusses 14 in verschiedene Richtungen.

## Patentansprüche

1. Verteiler zum Verbinden von Aktoren und/oder Sensoren mit einem elektrischen Gerät, wie einer Steuerung, mit einem Bauteil (1), an dem mehrere Anschlüsse (2) für die Versorgung der Aktoren und/oder Sensoren und die Weiterleitung der Aktoren-Sensoren-Signale vorgesehen sind, und einer Elektronikeinheit, die benachbart zu den Anschlüssen (2) an dem Bauteil (1) angeordnet ist, **dadurch gekennzeichnet, daß** die Elektronikeinheit von einem auf dem Bauteil (1) angeordneten Gehäuse (3, 13) aus Metall umgeben ist.

2. Verteiler nach Anspruch 1, **dadurch gekennzeichnet, daß** das Gehäuse (3, 13) abgedichtet an dem Bauteil (1) angebracht ist.

3. Verteiler nach Anspruch 1 oder 2, **dadurch gekennzeichnet, daß** an dem Gehäuse (3, 13) ein Kabelanschluß (4, 14, 24) vorgesehen ist, an dem ein Kabel im wesentlichen abgedichtet in den Innenraum des Gehäuses (3, 13) geführt ist.

4. Verteiler nach einem der Ansprüche 1 bis 3, **dadurch gekennzeichnet, daß** das Gehäuse (3, 13) aus Metall mehrteilig ausgebildet ist, und an jedem Gehäuseteil ein Kabelanschluß vorgesehen ist.

5. Verteiler nach einem der Ansprüche 1 bis 4, **dadurch gekennzeichnet, daß** das Gehäuse (3, 13) mit dem Bauteil (1) verschraubt ist und die Schrauben an dem Gehäuse in Draufsicht auf das Bauteil (1) mit dem Gehäuse drehsymmetrisch um eine Gehäusemittelachse angeordnet sind.

6. Verteiler nach Anspruch 5, **dadurch gekennzeichnet, daß** an dem Gehäuse (3, 13) und dem Bauteil (1) vier fluchtende Bohrungen vorgesehen sind, die in Draufsicht ein Quadrat ausbilden.

7. Verteiler nach einem der Ansprüche 1 bis 6, **dadurch gekennzeichnet, daß** an dem Bauteil (1) Bohrungen vorgesehen sind, mittels der ein erstes Gehäuseteil befestigt ist, und das erste Gehäuseteil weitere Bohrungen aufweist, an denen ein oder mehrere Gehäuseteile befestigbar sind.

8. Verteiler nach einem der Ansprüche 1 bis 7, **dadurch gekennzeichnet, daß** an dem Gehäuse ein Erdungsanschluß vorgesehen ist.

9. Verteiler nach einem der Ansprüche 1 bis 8, **dadurch gekennzeichnet, daß** alle Bauteile der Verteilers aus Metall ausgebildet sind.

10. Verteiler nach einem der Ansprüche 1 bis 9, **dadurch gekennzeichnet, daß** das Gehäuse (3, 13) aus Metall und das Bauteil (1) aus Kunststoff besteht.

11. Verteiler nach einem der Ansprüche 1 bis 10, **dadurch gekennzeichnet, daß** das Gehäuse (3, 13) aus Metall und das Bauteil (1) aus metallisiertem Kunststoff besteht.

12. Verteiler nach einem der Ansprüche 1 bis 11, **dadurch gekennzeichnet, daß** das Gehäuse (3, 13) aus einem Gehäuseunterteil, ein oder mehreren Zwischenrahmen mit jeweils einem Kabelanschluß und einem Gehäusedeckel besteht.

13. Verteiler nach Anspruch 12, **dadurch gekennzeichnet, daß** die Zwischenrahmen in Schritten von 90° gegeneinander verdreht angeordnet werden können.

14. Verteiler nach einem der Ansprüche 1 bis 13, **dadurch gekennzeichnet, daß** der Gehäusedeckel ein oder mehrere Kabelanschlüsse aufweist.
